# EUROPEAN PATENT APPLICATION

(11) **EP 2 690 469 A1**
(43) Date of publication of application: **29.01.2014**
(21) Application number: 12761418.8
(22) Date of filing: 21.03.2012
(51) Int. Cl.: G02B 1/11, C23C 14/30, C23C 14/32

(54) **REVERSE COATING METHOD FOR ANTIREFLECTION FILM**

(30) Priority: 22.03.2011 CN 201110069118
(71) Applicant: Watchman Tech. Co., Limited, Nanjing, Jiangsu 210008 (CN)
(72) Inventor: LV, Hsin-Tseng, Nanjing Jiangsu 210008 (CN)
(74) Representative: von Kreisler Selting Werner
(86) International application number: PCT/CN2012/072706
(87) International publication number: WO 2012/126365

(57) **Abstract**

This invention relates to a method for backward anti-reflective film coating to eliminate the light interfering image in optic imaging, when the optically transparent material (2) is being coated with anti-reflective film (1) by an electronic coating machine, the positive and negative charges on the electrode polarizing chambers of coating gun are reversed for coating the backward anti-reflective film (1). The anti-reflective film is coated by electronic ion coating method in this invention, the active surface of the coated film will be inversely inward to the optically transparent material; the ghost can be effectively eliminated, and the image will have no distinct color difference or any attachment; and meanwhile, the image definition is enhanced, the light reflection is controlled, and the effect and applicability of object image light characteristics are enhanced.

## Description

### Technical field

This invention relates to a coating technique, especially a backward coating technique, and particularly it introduces a method for backward anti-reflective film coating to eliminate the light interfering image in optic imaging.

### Background technique

When the sun shines the surface of an object, the light enters from one medium to another medium, light particles and light wave length are generated at the same time on different medium surfaces, so glare and ghost are generated by light reflection and refraction.

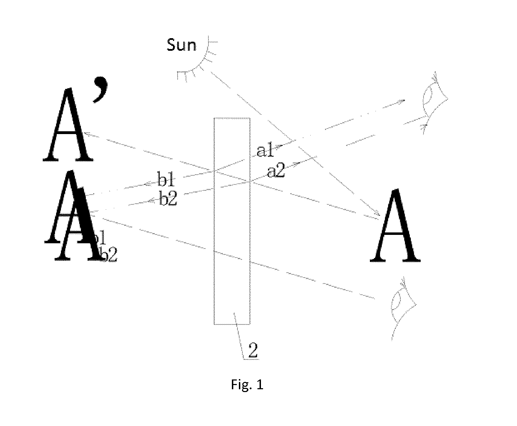

As shown in Fig. 1, when the incident light irradiates the light source image, i.e. Object A, the first reflection happens, and when the reflected light meets the optically transparent material, a piece of glass for example, light reflection and refraction happen at both sides of the glass, the distance between two light splitting points is the glass thickness. Because of the interference of reflected light and refracted light, the reflected light a1 and a2 generate glare, and the glare will be brightened in human's sight, the color saturation is decreased, and the object outline becomes dark; the refracted light b1 and b2 will generated overlapped images A_{b1} and A_{b2}, i.e. a ghost near the main transparent light image A'.

Normally when projecting on a piece of glass of 0.1mm thick above, double overlapped images, i.e. a ghost, will be generated if the projecting angle is not perpendicular to the glass in 90°. The cause of ghost is the refracting and splitting of light penetrating different mediums. By the refracted and split light, a weaker image will be generated on the glass surface, and appear at the front or back of the originally reflected image, and thus double overlapped images (ghost) are formed. E.g. usually when a man stands at the front of a large glass window and watching from a side to the window, he will see two layers of his image (ghost), and meanwhile the image is not clear, and the visual effect will make him tired and confused.

Color difference is used to eliminate the ghost in practice: by attaching a layer of film or painting a layer of semi-transparent paint (the film or paint must be transparent and with a darker color than the original image color); e.g. a layer of transparent but darker film is attached to the wind screen of a car to remove the ghost, but because of the color difference between the film and wind screen, the visual definition will be degraded, and the driver's sight will be influenced. So color difference is not the best method.

### Invention content

This invention intends to solve the double overlapped images (the ghost) generated by light interference, and introduce a method for backward anti-reflective film coating to eliminate the light interfering image in optic imaging.

### Technical plan of this invention:

This invention relates to a method for backward anti-reflective film coating to eliminate the light interfering image in optic imaging, in which, when coating the anti-reflective film on the optically transparent material by an electronic coating machine, the positive and negative charges on the electrode polarizing chambers of coating gun are reversed for backward coating, and thus a backward anti-reflecting film is formed on the optically transparent material surface.

The optically transparent material of this invention is high temperature resistant transparent material.

The high temperature resistant transparent material of this invention is high temperature resistant glass.

The optically transparent material of this invention is coated with backward anti-reflective film at the side to the light source image, i.e. to the real object.

The backward anti-reflective film of this invention is 0.1∼2.5nm thick.

The electronic coating machine of this invention is high temperature electronic vaporizing coating machine or normal temperature electronic coating machine.

### Beneficial effect of this invention:

The anti-reflective film is coated by electronic ion coating method in this invention, when using the electronic coating machine, the positive and negative charges on the electrode polarizing chambers of coating gun are reversed, the active surface of the coated film will be inversely inward to the optically transparent material; the ghost can be effectively eliminated, and the image will have no distinct color difference or any attachment; and meanwhile, the image definition is enhanced, the light reflection is controlled, and the effect and applicability of object image light characteristics are enhanced.

The novel technical method introduced by this invention can improve the effect which cannot be realized by common color difference method, it has a favorable function without degrading the visual effect, and it enhances the definition as the film characteristic of anti-reflective film (nearly 99% light transparency) can enhance the light transparency at the forward surface, and refract and reflect the light at the backward surface. The anti-reflective film is characterized in the unequal surfaces, one surface (forward active surface) is transparent, i.e. anti-reflective, and the other surface (backward active surface) is semi-transparent, i.e. polarizing (reflecting and refracting), but the polarizing piece has no zero angle light reflecting function or partially light refracting, and it is almost fully transparent with the forward action. This special optic design is advantageous for optic projecting and imaging for acquiring clearer images; various light interference in imaging are solved in light reflection and refraction.

This invention can be used in automobile industry, aviation industry, liquid crystal industry, displayer industry and communication industry.

### Explanation to attached drawings:

Fig. 1 is the schematic drawing for the cause of interfering image (double images overlapped).
Fig. 2 is the schematic drawing for the elimination of interring image.

In the drawings: 1- backward anti-reflective film; 2- optically transparent material.

### Detailed practice

This invention is further explained by the help of attached drawings and a detailed practical example.

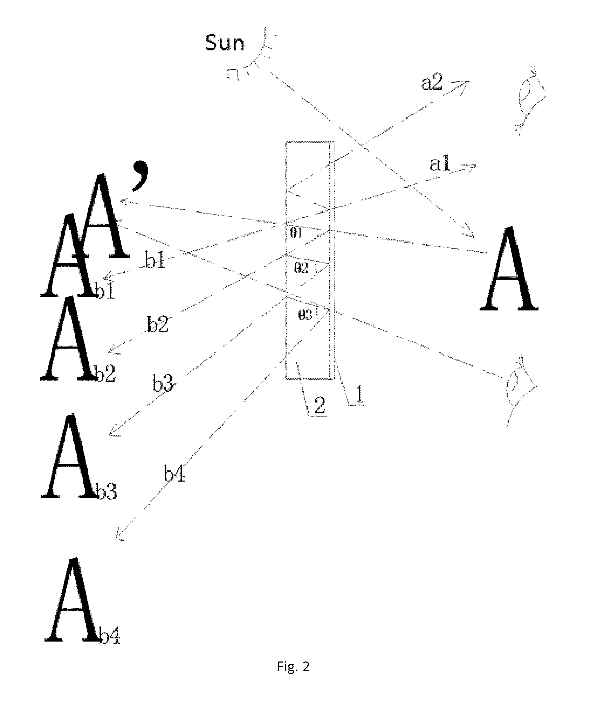

In Fig. 2, it relates to a method for backward anti-reflective film coating to eliminate the light interfering image in optic imaging, in which, when coating the anti-reflective film on the optically transparent material 2 by an electronic coating machine, the positive and negative charges on the electrode polarizing chambers of coating gun (DVE-240-PVD evaporating coating machine from Deyi Technology LTD) are reversed for backward coating, and thus a backward anti-reflecting film 1 is formed on the surface of optically transparent material 2.

The optically transparent material 2 of this invention is high temperature resistant transparent material, and can be high temperature resistant glass.

The optically transparent material 2 of this invention is coated with backward anti-reflective film 1 at the side to the light source image, i.e. to the real object. The active surface of the anti-reflective film 1 is inward to the optically transparent material 2, and the reflectivity of this surface is enhanced; the non-active surface is outward to the object, and the transparency of this surface is enhanced.

Generally, the optically transparent material 2 of this invention is coated with backward anti-reflective film 1 at the side to the light source image, i.e. to the real object, and is with polarizing film at the other side. Or, the backward anti-reflective film is further coated to the polarizing film if necessary, or both sides of the optically transparent material are coated with backward anti-reflective film.

The backward anti-reflective film of this invention is 0.1∼2.5nm thick.

The electronic coating machine of this invention is high temperature electronic vaporizing coating machine or normal temperature electronic coating machine.

In Fig. 2, when the incident light irradiates the light source image, i.e. the Object A, it is reflected at the first time, and when the reflected light meets the optically transparent material such as a piece of glass coated with backward anti-reflective film, reflection and refraction of split light happen to both sides of the glass. The active surface of the backward anti-reflective film 1 is inward to the glass, so the reflectivity of this surface is enhanced; the non-active surface is outward to the object, so the transparency of this surface is enhanced; and the split light is gradually weakened.

The reflected lights a1 and a2 are gradually weakened, the reflection angle is gradually enlarged, the reflected image is far from the human's sight, and glare is reduced.

Because the active surface of backward anti-reflective film 1 is inward to the glass, the reflectivity of this surface is enhanced, and the refracted light b2 of the main penetrating light is reflected by the glass surface before reflected between the active surface of backward anti-reflective film 1 and the non-film surface of glass; images Ab1, Ab2, Ab3 and Ab4 are generated by the refracted light b1, b2, reflected light b3 and b4 after refracted, the and brightness is gradually weakened. And meanwhile, the reflection angle of the main penetrating light after refracted is gradually enlarged, as shown in Fig. 2, θ1<θ2<θ3, the images Ab1, Ab2, Ab3 and Ab4 become further from the human's sight. The image A' of the main penetrating light becomes clearer with reduced light reflection; the ghost can be effectively eliminated without any distinct color difference or attachment, and the effect and applicability of object image light characteristics are enhanced.

Any part related to this invention but not mentioned in this specification is similar with the existing technique or can be realized by the existing technique.

## Claims

1. A method for backward anti-reflective film coating to eliminate the light interfering image in optic imaging, **characterized in that** when coating the anti-reflective film on the optically transparent material (2) by an electronic coating machine, the positive and negative charges on the electrode polarizing chambers of coating gun are reversed for backward coating, and thus a backward anti-reflecting film (1) is formed on the surface of optically transparent material (1).

2. The method for backward anti-reflective film coating to eliminate the light interfering image in optic imaging as mentioned in Claim 1, **characterized in that** the optically transparent material (2) of this invention is high temperature resistant transparent material.

3. The method for backward anti-reflective film coating to eliminate the light interfering image in optic imaging as mentioned in Claim 1, **characterized in that** the high temperature resistant transparent material of this invention is high temperature resistant glass.

4. The method for backward anti-reflective film coating to eliminate the light interfering image in optic imaging as mentioned in Claim 1, **characterized in that** the optically transparent material (2) of this invention is coated with backward anti-reflective film (1) at the side to the light source image, i.e. to the real object.

5. The method for backward anti-reflective film coating to eliminate the light interfering image in optic imaging as mentioned in Claim 1, **characterized in that** the active surface of the backward anti-reflective film (1) is toward the optically transparent material (2).

6. The method for backward anti-reflective film coating to eliminate the light interfering image in optic imaging as mentioned in Claim 1, **characterized in that** the backward anti-reflective film (1) of this invention is 0.1∼2.5nm thick.

7. The method for backward anti-reflective film coating to eliminate the light interfering image in optic imaging as mentioned in Claim 1, **characterized in that** the electronic coating machine of this invention is high temperature electronic vaporizing coating machine or normal temperature electronic coating machine.
